# EUROPEAN PATENT SPECIFICATION

(11) **EP 2 175 047 B1**
(45) Date of publication and mention of the grant of the patent: **08.02.2017**
(21) Application number: 08017713.2
(22) Date of filing: 09.10.2008
(51) Int. Cl.: C23C 14/56, H01J 37/32, H01J 37/34, B29C 59/14

(54) **Apparatus for plasma treating substrates and method**
Vorrichtung zur Plasmabehandlung von Substraten und Verfahren
Dispositif de traitement par plasma des substrats et procédé

(43) Date of publication of application: 14.04.2010
(73) Proprietor: Bobst Manchester Ltd, Heywood OL10 2TL (GB)
(72) Inventor: Barlow, Gary, Crosby L23 6XS (GB); Copeland, Nicholas, Hollingworth Via Hyde SK14 8HJ (GB)
(74) Representative: Poirier, Jean-Michel Serge

(56) References cited:
- EP-A- 0 997 926
- WO-A-96/34124
- WO-A1-99/04411
- WO-A1-2008/076364
- JP-A- 6 179 966
- JP-A- S5 990 627

## Description

### Technical Field

The invention relates to a) an apparatus for coating a substrate with a material in a chamber subject, during use, to substantial evacuation, and a plasma treater; and b) a method of treating a substrate in a process of coating by sputtering and/or evaporation in a chamber subject to substantial evacuation during use.

### Background Art

Reference is made to the Applicant's own plasma treater which is used to prepare the surface of a substrate before submission to the coating process, this treater is also called plasma pre-treater. This prior art plasma treater incorporates two cylindrical electrodes surrounding a magnetic means. The cylindrical electrodes are fixed relative to their casing. The known pre-treater generates a plasma cloud using a magnetic array, a reactive gas, an inert gas and a medium frequency alternating current (AC) power applied to an electrode.

By arranging that the substrate passes in close proximity to the electrode, plasma interacts with the surface of the substrate by removing moisture and other contaminants. It also acts to increase the number of nucleation sites through the introduction of polar groups, resulting in an improvement of the coating process with homogeneous surface morphology and less defects.

WO 2008/076364 A discloses an apparatus which comprises a coating station for the evaporation of aluminium and plasma treaters located upstream and downstream from the coating station, in order to perform a pre-treatment and post-treatment, respectively. The pressure in the plasma treating station is at rough vacuum and the pressure in the coating station is at high vacuum.

JP 59-90627 A discloses a plasma treater comprising a plurality of cylindrical electrodes surrounded by magnetic means.

It is further known a plasma treater which is used to prepare the surface of a substrate for the process following the coating process, this treater is also called plasma post-treater. A post treatment allows, for example,
unwanted particles to be removed from the coated substrate by the method of sputtering.

Unfortunately, the treater of the prior art has a number of drawbacks. It requires regular maintenance after a period of process due to the electrode tube being "dirtied" by the plasma deposits. These deposits can cause arcing which can result in the closing down of the power supply units which incorporate means for detecting this condition.

This maintenance requires the electrode tubes to be cleaned in order to remove the deposits. The preferred method of removal is a manual method using various abrasive materials.

One of the problems which the inventive concept addresses is how to avoid or at least minimise these frequent and labour intensive maintenance cycles.

### Disclosure of Invention

The essential features of the apparatus are defined in claim 1. The essential features of the corresponding process are defined in claim 9. Preferred embodiments are defined in claims 2 to 8 and 10 to 13, respectively. In a first aspect, the invention provides an apparatus comprising a coating station for coating a substrate by evaporation; and a treating station located upstream from said coating station equipped with a plasma pre-treater incorporating means for generating plasma in sufficient proximity to said substrate to treat said substrate; magnetic means for generating a magnetic field; and at least one cylindrical electrode surrounding said magnetic means; characterised in that said plasma pre-treater incorporates means for rotating said electrode about its longitudinal axis.

This configuration is particularly advantageous because it allows the pre-treatment to occur with the benefits of removing moisture and other contaminants which may be present on a substrate as the particles are removed by the method of sputtering. It avoids or at least minimises potential down times due to arcing and associated short circuits. It also increases the number of nucleation sites which will result in an improvement in the subsequent coating process. The coating is therefore homogeneous and with fewer defects than would otherwise be the case without such a pre-treatment.

In another aspect, the invention provides an apparatus comprising a coating station for coating a substrate by evaporation; and a treating station located downstream from said coating station equipped with a plasma post-treater incorporating means for generating plasma in sufficient proximity to said substrate to treat said substrate; magnetic means for generating a magnetic field; and at least one cylindrical electrode surrounding said magnetic means; characterised in that said plasma post-treater incorporates means for rotating said electrode about its longitudinal axis.

This configuration is particularly advantageous because it allows unwanted particles to be removed by the method of sputtering. It reduces the likelihood or entirely avoids any down time for specific cleaning and other maintenance actions associated with the treater. It also allows the coated surface to be prepared in an improved manner for the next process.

In a further aspect, the apparatus comprises both a plasma pre-treater and a plasma post-treater which incorporate means for rotating respective electrodes about their respective longitudinal axes. An overall beneficial effect arises by this combination by further improving the quality of coated substrate, reducing the likelihood of down time and improving the quality/throughput ratio.

In a further aspect, said plasma pre-treater is segregated from said evaporation station; whereby a second pressure level is present in the vicinity of said pre-treater whilst a first pressure level is present in the vicinity of said evaporation station; the second pressure level being greater than the first pressure level. This configuration allows the pre-treatment and the coating process to occur in separate environments for an overall beneficial effect as discussed above.

In a further aspect, said plasma post-treater is segregated from said evaporation station; whereby a second pressure level is present in the vicinity of said post-treater whilst a first pressure level is present in the vicinity of said evaporation station; the second pressure level being greater than the first pressure level. This configuration further improves the specific qualities of the individual operations whilst combining for improvements of quality of product and process.

In a further aspect, said pre-treater incorporates two electrodes and means for simultaneously rotating said electrodes. This configuration is particularly advantageous because it minimises the number of components required whilst achieving advantageous control of the pre-treatment process.

In a further aspect, said post-treater incorporates two electrodes and means for simultaneously rotating said electrodes. Similarly when compared to the pre-treater such a configuration further improves the overall quality of the produced substrate and the process whilst minimising the number of components required to achieve the improved effects.

In a further aspect, said apparatus further comprises a connector for connecting to a power source, brushes for transmitting power to said electrode during the rotation of said electrodes and a box sealing said brushes in an environment with a greater pressure than the evacuated chamber where said treater is located. This configuration allows the connection to be optimised whilst minimising and/or almost entirely avoiding undue wear of the brushes.

In another aspect, the invention provides a plasma treater comprising means for generating plasma in sufficient proximity to a substrate in order to treat said substrate; magnetic means for generating a magnetic field only in a front side of said treater where in use said substrate passes; at least one cylindrical electrode surrounding said magnetic means; and a body covering a rear side of said electrode;
characterised in that said electrode is rotatable about its longitudinal axis and said treater further incorporates means for rotating said electrode about its longitudinal axis.

This plasma treater is particularly advantageous because it avoids a prior art requirement of manual cleaning. It also allows unwarranted deposits on the electrode surface to be removed by the method of sputtering. It also allows the quality improvements of known pre-treatments to be achieved.

In a further aspect, said plasma treater comprises a connector for connection to a power source, brushes for transmitting power to said electrode during the rotation of said electrode and a box sealing said brushes in an environment, when said treater is in use, with a greater pressure than the evacuated chamber where said treater is located in use. This configuration is particularly advantageous to minimise any undue wear and tear of the power connection to the electrode.

In a further aspect, said treater incorporates two electrodes and means for simultaneously rotating said electrodes. This configuration is particularly advantageous because it minimises the number of components required whilst achieving a particularly regular and efficient pre-treatment process.

In a further aspect, said two electrodes are configured to rotate in opposite directions. This configuration is also particularly advantageous because it minimises the number of components required whilst producing a particularly compact overall configuration which may for example lend itself advantageously to retrofitting to an existing apparatus where the available space for retrofitting is minimal.

In a further aspect, said body incorporates channels for circulation of cooling liquid.

In a further aspect, said electrode incorporates channels for circulation of cooling liquid. These configurations are particularly advantageous because they allow the plasma affected areas to be cooled whilst allowing the treater to be relatively compact.

In another aspect, the invention provides a method of treating a substrate in a process of coating by evaporation in a chamber subject to substantial evacuation during use, comprising the steps of:
- placing, in a station located upstream from a coating station, a plasma pre-treater incorporating magnetic means for generating a magnetic field; and at least one cylindrical electrode surrounding said magnetic means;
- generating plasma; and
- submitting said substrate to be coated to said generated plasma in the vicinity of said plasma pre-treater;
characterised in that said method further comprises the step of rotating said electrode about its longitudinal axis as the substrate is displaced past the treater.

In another aspect, the invention provides a method of treating a substrate in a process of coating by evaporation in a chamber subject to substantial evacuation during use, comprising the steps of:
- placing, in a station located downstream from a coating station, a plasma post-treater incorporating magnetic means for generating a magnetic field; and at least one cylindrical electrode surrounding said magnetic means;
- generating plasma; and
- submitting said coated substrate to plasma in the vicinity of said plasma post-treater;
characterised in that said method further comprises the step of rotating said electrode about its longitudinal axis as the substrate is displaced past the treater.

In a further aspect, the method comprises the steps of submitting said substrate to both a pre-treater and a post-treater.

In a further aspect, the invention provides a method further comprising the steps of segregating said pre-treater from said evaporation station; and applying a second pressure in the vicinity of said pre-treater whilst applying a first pressure in the vicinity of said evaporation station; the second pressure level being greater than the first pressure level.

In a further aspect, the invention provides a method further comprising the steps of segregating said post-treater from said evaporation station; and applying a second pressure in the vicinity of said post-treater whilst a first pressure level is present in the vicinity of said evaporation station; the second pressure level being greater than the first pressure level.

In another aspect, the invention provides a plasma treater substantially as described and/or illustrated in any appropriate combination of the accompanying text and/or figures.

### Brief Description of Figures in the Drawings

Figure 1 shows a perspective view of a plasma treater according to the invention;
Figure 2 shows a cross-sectional view of a seal and bearing arrangement for an extremity of an electrode;
Figure 3 shows a top view of the atmospheric box end of the treater;
Figure 4 shows a perspective view of the atmospheric box of the treater and of an arrangement of services associated with the treater.

### Best Mode for Carrying Out the Invention

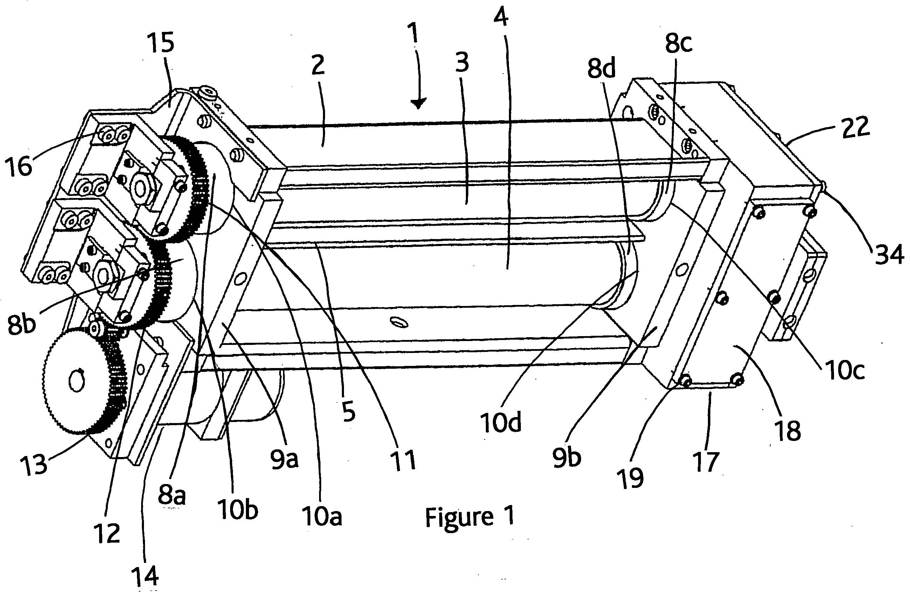

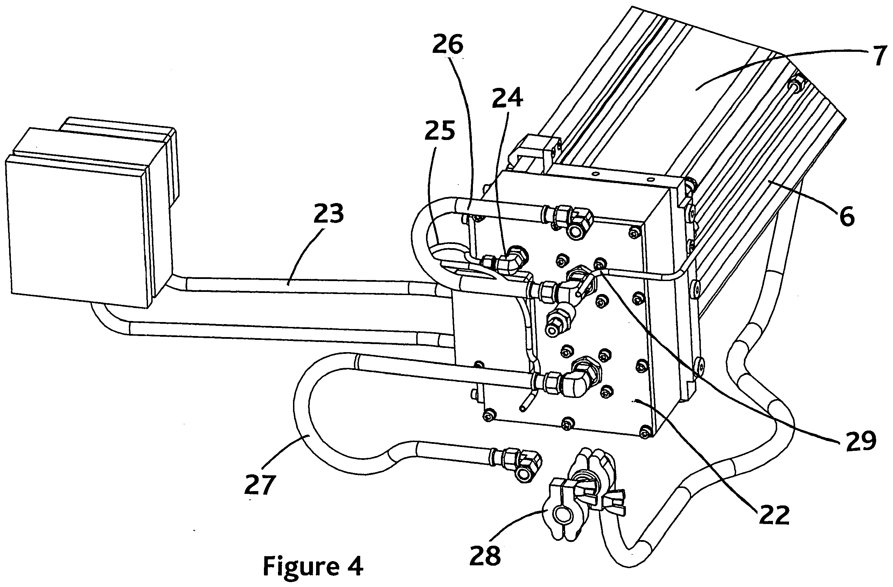

Figure 1 shows a treater generally referenced 1. Treater 1 incorporates an aluminium extrusion body 2 with an internal W-shaped in cross-section configuration in order to accommodate cylindrical electrodes 3 and 4 in respective cavities. Body 2 incorporates a number of cooling channels for a suitable cooling fluid to pass such as water in order to keep the plasma affected areas cooled. A web 5 splits the body into the two electrode receiving cavities. As can be seen in Figure 4, the rear portion 6 and the upper portion 7 of the body are substantially flat. Seals 8a, 8b, 8c and 8d are provided at either end of the electrode. These seals may take the form of a ceramic shield. The respective seals are supported in respective blocks 9a and 9b incorporating mating cylindrical bearing surfaces 10a, 10b, 10c and 10d.

Each electrode is connected and rotatable with a gear such as gear 11 and gear 12. Gears 11 and 12 incorporate a plurality of teeth which are suitable for being meshed with the teeth of a neighbouring gear; whereby when gear 12 is rotated in a direction, gear 11 is rotated in a counter direction. As an alternative embodiment, gears 11 and 12 may be disconnected from one another and rotated in the same direction. A driving gear 13 is located in communication with gear 12. Gear 13 is driven by a motor and/or gear box assembly 14.

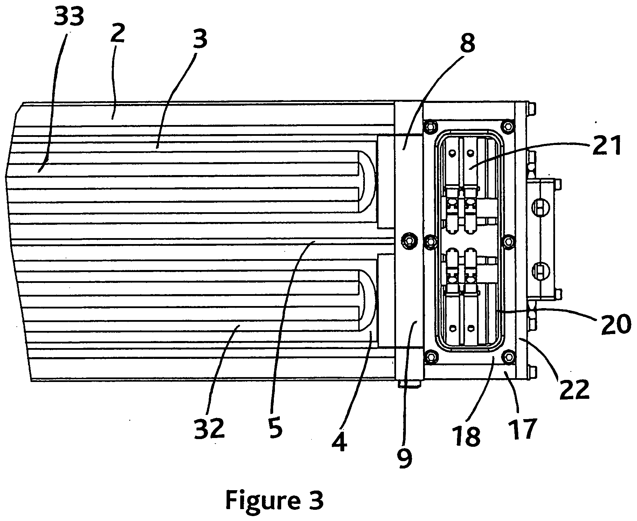

Race tracks 32 and 33 (partially shown in figure 3) are provided where the effective plasma treatment occurs as the substrate is displaced in front of the treater.

A unitary support plate 15 is envisaged with a number of fastening means such as fastening means 16 in order to allow the treater to be secured to an appropriate support surface in, for example, an apparatus for coating a substrate with a material in a chamber subject, during use, to substantial evacuation, also called evacuation chamber or vacuum chamber. Further attachment means are envisaged at the opposite end of the treater to secure the treater at both its extremities if necessary. The unitary plate 15 is L-shaped in cross-section and provides a number of cut-outs to accommodate the various rotatable seals.

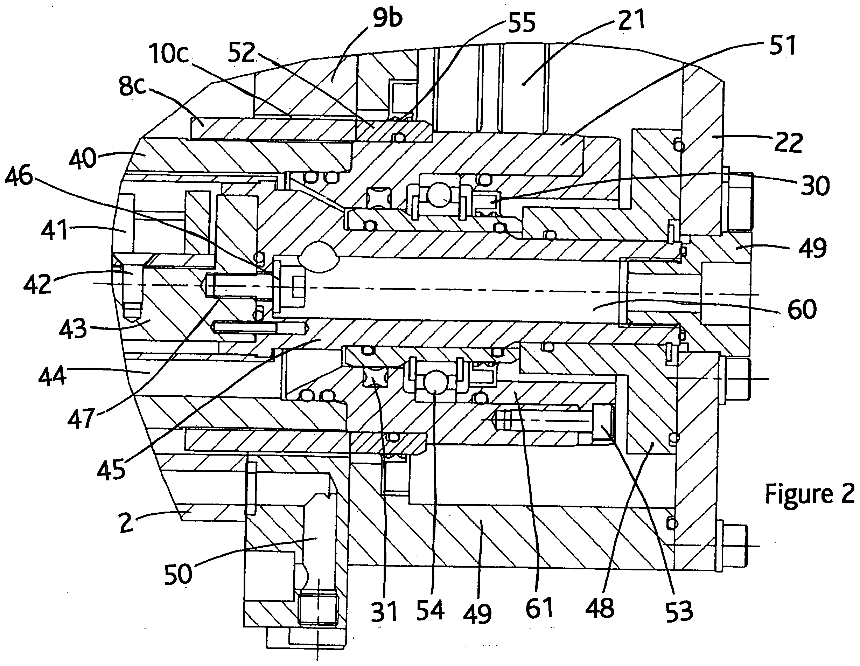

An atmospheric box 17 is provided at the opposite extremity to the driving arrangement which has just been described. The atmospheric box 17 provides within it an environment with a greater pressure than the evacuation chamber which keeps brushes 21 which it encloses out of the vacuum environment in order to reduce the likelihood of arcing between the brushes and the electrodes. The atmospheric box incorporates an access window 18 with sealing means located between the window and the box 17. A number of fastening means such as fastener 19 are located through apertures provided at regular intervals along the periphery of the window in order to accommodate corresponding fasteners. The access window is of greater dimensions than the actual aperture 20 (as shown in figure 3) provided by the box. Appropriate connectors for a connection to a power source are envisaged which would lead to the brushes 21 (as shown in figure 2 and figure 3). In a preferred embodiment, the brushes are made of carbon or other similar material facilitating the conduction of electricity from the power source to the electrode whilst the electrode is being rotated. A lateral panel 22 is provided with a number of regularly spaced fastening means such as screw 34. The lateral panel incorporates a number of cut-outs corresponding to individual services as shown in further detail in Figure 4.

Figure 4 shows the power feed 23 establishing the connection between a power supply and the treater. A breather 24 is provided as a connector between the atmospheric box and a nylon flexible tube 25 for connection to a location outside of the vacuum chamber in which a treater is located in use. A cooling water feed 26 is provided to feed cooling fluid to the body 7 and/or electrodes 3 and 4. Once the cooling fluid has circulated through the appropriate parts of the treater, it is then returned through return line 27. A vacuum gauge test point is also envisaged. Furthermore, a gas feed 29 is provided. The gas mixtures or gases are preferably selected from the following group: 80%Ar/20%O₂, 80%N₂/20%O₂, 80%He/20%O₂, and 100%O₂. The gas distribution is carried out by means of channels in the aluminium extrusion of the body. In the case of gas mixtures, the gases have been previously mixed and fed into either end of the extrusion to ensure uniformity of distribution.

Inside the electrodes, there is provided magnetic means for applying a field to the area immediately in front of the treater where the substrate is past during the process.

The velocity of the rotation of the electrodes may be kept between 0 and 1000 rpm (revolutions per minute). The velocity of the rotation of the electrodes is preferably advantageously kept between 0 and 6 rpm (revolutions per minute) and the preferred working temperature is approximately 50° Celsius with a cooling water rate of 8 litres per minute. The electrodes are preferably selected from the following group:
aluminium, stainless steel, non-ferrous metals, ceramic, titanium, and appropriate polymers.

As can be seen in Figure 2, a variety of seals are employed such as a ceramic seal 8, a grease seal 30 and a rotating seal 31.

Figure 2 shows a cross-section at the extremity of electrode 3. Rotatable electrode shield 40 houses magnetic means 41. The electrode shield 40 is dynamic whilst the magnetic means are stationary. A screw 42 is provided to secure the magnetic means 41 to a shaft 43. As can be seen in the figure, the magnetic means are provided on only one side of shaft 43 which is the front side of the treater in order to act on the passing substrate. A water channel 44 is provided between electrode shield 40 and shaft 43. Shaft 43 is secured to a bush 45 by appropriate fastening means such as screw 46 which engages a corresponding threaded recess 47. Along the central axis of bush 45, there is also provided a channel 60 through which water or any other suitable cooling liquid enters the electrode. Bush 45 is also static whilst being secured to plate 22 via a further bush 48 and a screw threaded connector 49. Both plate 22 and box wall 49 are static. Block 9b is also static and presents a cylindrical bearing surface 10c. In block 9b, there is also provided a further water or fluid channel 50 for communicating cooling fluid to and/or from body 2 of the treater.

The following dynamic components are also present: the rotatable electrode shield 40, its supporting bush 51 which is in communication with brushes such as brush 21, seal 8c, hard seal runner 52, end portion 61 and its corresponding fastening means 53.

A ball bearing 54 is provided between the static portions and the dynamic portions. A further dynamic seal 55 is provided between the rotatable portions and the box wall 49. A further dynamic seal 31 is provided between the dynamic and static portions.

The treater may be placed in a treating station located upstream from a coating station of a vacuum coater in order to perform a pre-treatment. It is located in a part of the vacuum coater where a relatively high pressure is present when compared to the pressure in a separate station of the vacuum coater where the actual process of evaporating a material such as aluminium takes place.

Advantageously, the vacuum coater incorporates a further segregated treating station located downstream from the coating station in order to perform a post-treatment. The pressure in the treating station is relatively high compared to the pressure in the coating station in order to facilitate post-treatment.

## Claims

1. Apparatus for coating a substrate with a material in a chamber subject, during use, to substantial evacuation; which includes a coating station within said chamber for coating a substrate by evaporation at a first pressure; at least one treating station disposed in series with and segregated from said coating station and equipped with a plasma treater (1) incorporating means for generating plasma in sufficient proximity to said substrate to treat said substrate, the plasma being at a second pressure, the second pressure being greater than the first pressure; the treating station comprising magnetic means (41) for generating a magnetic field; and at least one cylindrical electrode (3, 4) surrounding said magnetic means (41), said plasma treater (1) incorporating means (11, 12, 13, 14) for rotating said electrode (3, 4) about its longitudinal axis, thereby in operation causing plasma deposits on the electrode surface to be removed.

2. Apparatus according to claim 1, wherein a treating station is located upstream from said coating station in order to perform a pre-treatment.

3. Apparatus according to claim 1 or claim 2, wherein a treating station is located downstream from said coating station in order to perform a post-treatment.

4. Apparatus according to any of the preceding claims, wherein said plasma treater (1) incorporates two electrodes (3, 4) and means (13) for simultaneously rotating said electrodes.

5. Apparatus according to claim 4, wherein said two electrodes (3, 4) are configured to rotate in opposite directions.

6. Apparatus according to any preceding claim, wherein said electrodes comprises aluminium, stainless steel, non-ferrous metal, ceramic, titanium or polymer.

7. Apparatus according to any preceding claim, wherein the coating station is arranged to coat the substrate with aluminium.

8. Apparatus according to any of the preceding claims, further comprising a connector (23) for connection to a power source, brushes (21) for transmitting power to said electrode (3, 4) during the rotation of said electrode and a box (17) sealing said brushes in an environment with a greater pressure than the evacuated chamber where said treater is located.

9. A method of treating a substrate in a process of coating by evaporation in a chamber subject to substantial evacuation during use, comprising the steps of:
• providing a coating station operating at a first pressure;
• disposing a plasma treater (1) in a treating station in series with and segregated from said coating station; said plasma treater (1) incorporating magnetic means (41) for generating a magnetic field, and at least one cylindrical electrode (3, 4) surrounding said magnetic means (41);
• generating plasma, the plasma being at a second pressure, the second pressure being greater than the first pressure; and
• submitting said substrate to be coated to said generated plasma in the vicinity of said plasma treater (1);
the method further comprising the step of rotating said electrode (3, 4) about its longitudinal axis as the substrate is displaced past the treater (1), thereby causing plasma deposits on the electrode surface to be removed.

10. A method according to claim 9, comprising the step of disposing a plasma treater (1) in a treating station located upstream from said coating station in order to perform a pre-treatment.

11. A method according to claim 9 or claim 10, comprising the step of disposing a plasma treater (1) in a treating station located downstream from said coating station in order to perform a post-treatment.

12. A method according to any one of claims 9 to 11, further comprising the steps of providing a second electrode and rotating said electrodes in opposite directions.

13. A method according to any one of claims 9 to 12, comprising the step of coating the substrate in the coating station with aluminium.

## Patentansprüche

1. Vorrichtung zum Beschichten eines Substrats mit einem Material in einer Kammer, die während der Verwendung einer beträchtlichen Evakuierung unterworfen wird; die eine Beschichtungsstation innerhalb der Kammer zum Beschichten eines Substrats durch Verdampfen bei einem ersten Druck umfasst; mindestens eine Behandlungsstation mit der Beschichtungsstation in Serie angeordnet und davon getrennt und mit einer Plasmabehandlungsvorrichtung (1) ausgestattet ist, die Mittel zum Erzeugen von Plasma in ausreichender Nähe zu dem Substrat enthält, um das Substrat zu behandeln, wobei das Plasma sich bei einem zweiten Druck befindet, wobei der zweite Druck höher als der erste Druck ist; wobei die Behandlungsstation magnetische Mittel (41) zum Erzeugen eines magnetischen Felds umfasst; und wobei mindestens eine zylindrische Elektrode (3, 4) das magnetische Mittel (41) umgibt, wobei die Plasmabehandlungsvorrichtung (1) Mittel (11, 12, 13, 14) zum Rotieren der Elektrode (3, 4) um ihre Längsachse enthält, wodurch sie im Betrieb verursacht, dass Plasmaablagerungen auf der Elektrodenoberfläche entfernt werden.

2. Vorrichtung nach Anspruch 1, wobei eine Behandlungsstation sich stromaufwärts von der Beschichtungsstation befindet, um eine Vorbehandlung auszuführen.

3. Vorrichtung nach Anspruch 1 oder 2, wobei eine Behandlungsstation sich stromabwärts von der Beschichtungsstation befindet, um eine Nachbehandlung auszuführen.

4. Vorrichtung nach einem der vorhergehenden Ansprüche, wobei die Plasmabehandlungsvorrichtung (1) zwei Elektroden (3, 4) und Mittel (13) zum gleichzeitigen Rotieren der Elektroden enthält.

5. Vorrichtung nach Anspruch 4, wobei die zwei Elektroden (3, 4) zum Rotieren in entgegengesetzten Richtungen konfiguriert sind.

6. Vorrichtung nach irgendeinem vorhergehenden Anspruch, wobei die Elektroden Aluminium, Edelstahl, eisenfreies Metall, Keramik, Titan oder Polymer umfassen.

7. Vorrichtung nach irgendeinem vorhergehenden Anspruch, wobei die Beschichtungsstation zum Beschichten des Substrats mit Aluminium angeordnet ist.

8. Vorrichtung nach einem der vorhergehenden Ansprüche, ferner einen Anschluss (23) zum Anschließen an eine Energiequelle, Bürsten (21) zum Übertragen von Energie an die Elektrode (3, 4) während der Rotation der Elektrode und einen Kasten (17) umfassend, der die Bürsten in einer Umgebung mit höherem Druck als der evakuierten Kammer, wo die Behandlungsvorrichtung sich befindet, versiegelt.

9. Verfahren zum Behandeln eines Substrats bei einem Vorgang zum Beschichten durch Verdampfen in einer Kammer, die während der Verwendung einer beträchtlichen Evakuierung unterworfen wird; umfassend die Schritte des:
- Bereitstellens einer Beschichtungsstation, die bei einem erst en Druck arbeitet;
- Positionierens einer Plasmabehandlungsvorrichtung (1) in eine Behandlungsstation in Serie mit und gegtrennt von der Beschichtungsstation; wobei die Plasmabehandlungsvorrichtung (1) magnetische Mittel (41) zum Erzeugen von eines magnetischen Felds und mindestens eine zylindrische Elektrode (3, 4), die das magnetische Mittel (41) umgibt, enthält;
- Erzeugens von Plasma, wobei das Plasma sich bei einem zweiten Druck befindet, wobei der zweite Druckhöher als der erste Druck ist; und
- Unterwerfens des zu beschichtendem Substrats dem erzeugten Plasma in der Nähe der Plasmabehandlungsvorrichtung (1);
wobei das Verfahren ferner den Schritt des Rotierens der Elektrode (3, 4) um ihre Längsachse umfasst, während das Substrat an der Behandlungsvorrichtung (1) vorbeigeschoben wird, wodurch sie verursacht, dass Plasmaablagerungen auf der Elektrodenoberfläche entfernt werden.

10. Verfahren nach Anspruch 9, umfassend den Schritt des Anordnens einer Plasmabehandlungsvorrichtung (1) in einer Behandlungsstation, die sich stromaufwärts von der Beschichtungsstation befindet, um eine Vorbehandlung auszuführen.

11. Verfahren nach Anspruch 9 oder 10, umfassend den Schritt des Anordnens einer Plasmabehandlungsvorrichtung (1) in einer Behandlungsstation, die sich stromabwärts von der Beschichtungsstation befindet, um eine Nachbehandlung auszuführen.

12. Verfahren nach einem der Ansprüche 9 bis 11, ferner die Schritte des Bereitstellens einer zweiten Elektrode und Rotieren der Elektroden in entgegengesetzten Richtungen umfassend.

13. Verfahren nach einem der Ansprüche 9 bis 12, umfassend den Schritt des Beschichtens des Substrats in der Beschichtungsstation mit Aluminium.

## Revendications

1. Appareil de revêtement d'un substrat par un matériau dans une chambre sujette, en cours d'utilisation, à une mise sous vide sensible; qui comprend un poste de revêtement dans ladite chambre pour revêtir un substrat par évaporation à une première pression ; au moins un poste de traitement disposé en série avec et séparé dudit poste de revêtement et équipé d'un dispositif de traitement au plasma (1) incorporant des moyens pour générer du plasma à proximité suffisante dudit substrat pour traiter ledit substrat, le plasma étant à une seconde pression, la seconde pression étant supérieure à la première pression ; le poste de traitement comprenant des moyens magnétiques (41) pour générer un champ magnétique ; et au moins une électrode cylindrique (3,4) entourant lesdits moyens magnétiques (41), ledit dispositif de traitement au plasma (1) incorporant des moyens (11, 12, 13, 14) pour faire tourner ladite électrode (3, 4) autour de son axe longitudinal, en sorte de provoquer en service l'élimination de dépôts de plasma sur la surface de l'électrode.

2. Appareil selon la revendication 1, dans lequel un poste de traitement est situé en amont dudit poste de revêtement afin d'effectuer un prétraitement.

3. Appareil selon la revendication 1 ou la revendication 2, dans lequel un poste de traitement est situé en aval dudit poste de revêtement afin d'effectuer un post-traitement.

4. Appareil selon l'une quelconque des revendications précédentes, dans lequel ledit dispositif de traitement au plasma (1) incorpore deux électrodes (3, 4) et des moyens (13) pour faire tourner simultanément lesdites électrodes.

5. Appareil selon la revendication 4, dans lequel lesdites deux électrodes (3, 4) sont configurées pour tourner dans des sens opposés.

6. Appareil selon l'une quelconque des revendications précédentes, dans lequel lesdites électrodes comprennent de l'aluminium, de l'acier inoxydable, un métal non ferreux, une céramique, du titane ou un polymère.

7. Appareil selon l'une quelconque des revendications précédentes, dans lequel le poste de revêtement est agencé pour revêtir le substrat par de l'aluminium.

8. Appareil selon l'une quelconque des revendications précédentes, comprenant en outre un connecteur (23) pour connexion à une source d'alimentation, des balais (21) pour transmettre de l'énergie à ladite électrode (3, 4) au cours de la rotation de ladite électrode et une boîte (17) scellant lesdits balais dans un environnement sous une pression plus élevée que celle de la chambre placée sous vide où ledit dispositif de traitement est situé.

9. Procédé de traitement d'un substrat dans un processus de revêtement par évaporation dans une chambre soumise à une mise sous vide sensible en cours d'utilisation, comprenant les étapes consistant à :
• fournir un poste de revêtement fonctionnant à une première pression;
• disposer un dispositif de traitement au plasma (1) dans un poste de traitement en série avec ledit poste de revêtement et séparé de celui-ci ; ledit dispositif de traitement au plasma (1) incorporant des moyens magnétiques (41) pour générer un champ magnétique et au moins une électrode cylindrique (3, 4) entourant lesdits moyens magnétiques (41) ;
• générer un plasma, le plasma étant à une seconde pression, la seconde pression étant supérieure à la première pression ; et
• soumettre ledit substrat à revêtir audit plasma généré au voisinage dudit dispositif de traitement au plasma (1) ;
le procédé comprenant en outre l'étape de rotation de ladite électrode (3,4) autour de son axe longitudinal lorsque le substrat est déplacé devant le dispositif de traitement (1), de manière à entraîner l'élimination de dépôts de plasma sur la surface de l'électrode.

10. Procédé selon la revendication 9, comprenant l'étape de mise en place d'un dispositif de traitement au plasma (1) dans un poste de traitement situé en amont dudit poste de revêtement afin d'effectuer un prétraitement.

11. Procédé selon la revendication 9 ou la revendication 10, comprenant l'étape de mise en place d'un dispositif de traitement (1) dans un poste de traitement situé en aval dudit poste de revêtement afin d'effectuer un post-traitement.

12. Procédé selon l'une quelconque des revendications 9 à 11, comprenant en outre les étapes de fourniture d'une seconde électrode et de rotation desdites électrodes dans des sens opposés.

13. Procédé selon l'une quelconque des revendications 9 à 12, comprenant l'étape de revêtement du substrat par de l'aluminium dans le poste de revêtement.
